Europäisches Patentamt

European Patent Office

Office européen des brevets

(11) Veröffentlichungsnummer: **0 213 530 B1**

# EUROPÄISCHE PATENTSCHRIFT

(45) Veröffentlichungstag der Patentschrift:
31.01.90

(51) Int. Cl.⁴: **G01R 31/34, G01R 27/20**

(21) Anmeldenummer: **86111399.1**

(22) Anmeldetag: **18.08.86**

(54) Verfahren zum Messen des Übergangswiderstandes von Leitungsanschlüssen in einem Netzwerk elektrisch parallel geschalteter Leiter und zugehörige Messanordnung.

(30) Priorität: **21.08.85 DE 3529923**

(43) Veröffentlichungstag der Anmeldung:
**11.03.87 Patentblatt 87/11**

(45) Bekanntmachung des Hinweises auf die Patenterteilung:
**31.01.90 Patentblatt 90/5**

(84) Benannte Vertragsstaaten:
**AT CH DE FR GB IT LI SE**

(56) Entgegenhaltungen:
**DE-A- 2 448 337**
**US-A- 3 950 630**

**IBM TECHNICAL DISCLOSURE BULLETIN, Band 20, Nr. 8, Januar 1978, Seiten 3035,3036, New York, US; R.W. KEIM: "Measuring contact resistance"**

(73) Patentinhaber: **Siemens Aktiengesellschaft, Wittelsbacherplatz 2, D-8000 München 2(DE)**

(72) Erfinder: **Dengler, Jochen, Dipl.-Ing., Hans-Birkmayr-Strasse 53, D-8600 Bamberg(DE)**

**Beschreibung**

Die Erfindung bezieht sich auf ein Verfahren zum Messen des Übergangswiderstandes von Leitungsanschlüssen in einem Netzwerk elektrisch parallel geschalteter Leiter, die im wesentlichen gleichartig sind, insbesondere zur Messung der Schweißwiderstände zwischen Wicklungen und Kollektor-Lamellen bei elektrischen Motoren. Daneben bezieht sich die Erfindung auch auf eine Meßanordnung zur Durchführung des Verfahrens, mit Strom- bzw. Spannungsquellen, einer Meßsonde für Spannungen sowie zugehörigen Spannungsmeßeinrichtungen.

Beispielsweise bei elektrischen Motoren mit Kommutator müssen die Wicklungen des Läufers mit den einzelnen Lamellen des zugehörigen Kollektors elektrisch verbunden werden. Eine Aussage über die Qualität dieser Verbindung liefert dabei der entstehende Übergangswiderstand zwischen Lamelle und Wicklungsanschluß. Das Anschließen der Wicklungsenden erfolgt üblicherweise durch Preßschweißen, wobei der Schweißwiderstand bei guter Verbindung im Bereich von einigen μ Ω liegt.

Bei der Fertigung von derartigen Motoren werden neben einer Prüfung der Läuferwicklungen auf Isolationsfestigkeit auch alle Kollektorlamellen elektrisch geprüft. Dabei wird einerseits der Gesamtwiderstand einer einzelnen Lamelle und andererseits der Schweißwiderstand gemessen. Da die Wicklungsenden in hakenartige Anschlüsse der Kollektorlamellen eingeschweißt werden, spricht man in der Praxis auch vom sogenannten Hakenwiderstand.

Bei einer vollautomatisierten Fertigung muß die Prüfung des Läufers hinsichtlich oben angegebener Kriterien möglichst schnell erfolgen. Die Widerstandsbestimmungen könnten zwar nach üblichen Strom/Spannungs-Meßmethoden erfolgen. Es wird jedoch gefordert, daß speziell der sogenannte Hakenwiderstand für jede Lamelle in einigen Millisekunden und darüber hinaus auch möglichst genau gemessen werden soll. Das heißt im einzelnen, daß bei Bestimmung der Übergangswiderstände insbesondere die Widerstände der Wicklungen selbst ausgeschaltet werden müssen.

Es ist ein Prüfverfahren bekannt, bei dem für die Messung der Hakenwiderstände auch die Widerstände der Wiklungen selbst eingehen. Dadurch ist die Auflösung des Verfahrens vergleichsweise schlecht und liegt nur im Milliohmbereich, wodurch dieses Verfahren speziell zur Qualitätsbeurteilung der Hakenwiderstände nicht ausreichend ist.

Aufgabe der Erfindung ist es daher, ein Verfahren und eine zugehörige Vorrichtung vorzuschlagen, mit denen speziell Übergangswiderstände von Leitern in Netzwerken präzise gemessen werden können. Dabei muß als Nebenbedingung gewährleistet sein, daß das Verfahren möglichst schnell, und zwar in der Zeit von Millisekunden durchführbar ist.

Die Aufgabe wird erfindungsgemäß dadurch gelöst, daß jeweils im Netzwerk mit drei Zweigen gemessen wird, von denen der im mittleren Zweig befindliche Übergangswiderstand bestimmt werden soll, wozu in einem ersten Verfahrensschritt über den ersten Zweig dem Netzwerk ein definierter Strom bzw. eine definierte Spannung eingeprägt wird und in einem zweiten Verfahrensschritt im Meßzweig ein dem in diesem meßzweig fließendem Strom gleich grßer Gegenstrom bzw. eine Gegenspannung eingeprägt wird, so daß der Verknüpfungspunkt der Leiter auf Nullpotential liegt, und die dafür notwendige Spannung gemessen wird, woraus der Übergangswiderstand im mittleren Zweig ohne den Leiterwiderstand ermittelbar ist.

Mit der Erfindung ist ein Verfahren geschaffen, bei dem die Widerstände der Wicklungen einerseits und auch die Sondenübergangswiderstände nicht in die Messung eingehen. Insbesondere bei der Prüfung der Läufer von Elektromotoren mit einer Vielzahl von Kollektorlamellen sind für die Messung eines einzelnen Übergangswiderstandes alle Lamellen bis auf drei mit dem Bezugspunkt der Meßelektronik verbunden. Potentialdifferenzen bzw. Spannungen werden dabei nach der Vierpolmethode gemessen, wozu jeweils separate Leiter für Spannung und Strom verwendet sind.

Bei der zugehörigen Vorrichtung zur Durchführung des Verfahrens sind im Netzwerk dem ersten und zweiten Leiter zwei jeweils eine Strom- bzw. Spannungsquelle mit entgegengesetzter Polarität zugeordnet und die Strom- bzw. Spannungsquellen auf diskrete Werte einstellbar und im Meßbetrieb gegebenenfalls vom eingestellten Stromwert auf die bei diesem konstantstrom notwendige Spannung umschaltbar.

Obiges Verfahren kann durch entsprechenden Aufbau der zugehörigen Vorrichtung sowohl analog als auch digital realisiert werden. Insbesondere bei einer digitalen Lösung mit entsprecht über die Meßwerte steuerbaren bzw. vorprogrammierbaren Spannungsquellen mittels eines zugehörigen Mikroprozessorsystems läßt sich eine einzelne Messung außerordentlich schnell durchführen, so daß insgesamt ein proxisgerechtes Verfahren, beispielsweise für die Prüfung von Motorläufern, geschaffen ist.

Weitere Einzelheiten und Vorteile der Erfindung ergeben sich aus der nachfolgenden Figurenbeschreibung von Ausführungsbeispielen in Verbindung mit den wieteren Unteransprüchen. Es zeigen

FIG 1 in perspektivischer Darstellung den Läufer eines Motors mit angedeuteten Kommutator-Lamellen und zugehörigen Wicklungsanschlüssen.

FIG 2 das zugehörige elektrische Ersatzschaltbild.

FIG 3 ein Schaltbild für eine erste, analaog arbeitende Meßanordnung zur Ermittlung eines Schweißwiderstandes.

FIG 4 ein Schaltbild für eine zweite, im wesentlichen digital arbeitende Meßanordnung unter Einsatz eines Mikroprozessors als Steuer- und Programmiereinheit und

FIG 5 eine schematische Darstellung einer einzelnen Lamelle mit zugehörigem Hakenanschluß und vorteilhafte Positionierung der zugehörigen Meßsonde.

In den Figuren sind identische Teile mit gleichen Bezugszeichen versehen. Die Figuren werden teilweise zusammen beschrieben.

In der FIG I ist der Läufer eines Gleichstromoder Allstrommotors dargestellt: Solche Motoren weisen einen Rotor I auf, der Träger einer Anzahl separater elektrischer Wicklungen ist. Beispielsweise sind zwölf oder mehr Wicklungen vorhanden, die eine bestimmte Windungszahl haben und in Schlitzen 4 bis 7 des stanzpaketierten Rotorkörpers I geführt sind. Einzelne in FIG I nur angedeutete Wicklungsdrähte II bis 22 werden auf einen Kommutator 3 geführt, der aus einzelnen angedeuteten Kollektorlamellen 3I bis 42 besteht und mit den Wicklungsenden elektrisch verbunden ist. Dafür sind rotorseitig entsprechende Anschlußelemente vorhanden. Der gesamte Rotor I ist auf einer Welle 2 drehbar gelagert und in bekannter Weise Teil eines Elektromotors.

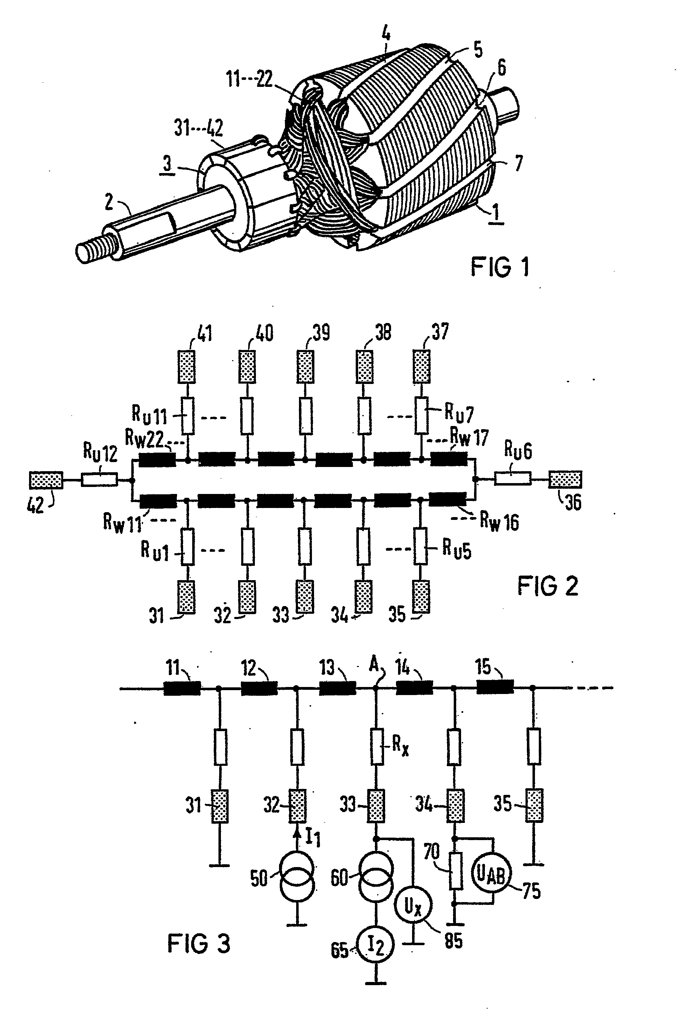

In der FIG 2 sind im elektrischen Ersatzschaltbild für I2 Wicklungen die Widerstände der einzelnen Wicklungen mit $R_{Wi}$ bezeichnet und werden nachfolgend mit Bezugszeichen II bis 22 durchnumeriert. Jede elektrische Wicklung, beispielsweise die Wicklung II ist mit einem Windungsende an eine der Lamellen $L_i$ für i=I,...I2, beispielsweise die Lamelle 3I, und mit dem anderen Windungsende zusammen mit dem Windungsende der nächsten Wicklung I2 an der nächsten Lamelle $L_{i+I}$ für i=I,...I2, beispielsweise Lamelle 32, kontaktiert. Insgesamt bilden die Kollektorlamellen $L_i$ mit den Widerständen der Wicklungen $R_{Wi}$ ein Netzwerk von elektrisch parallel geschalteten Leitern, wobei die einzelnen sich entsprechenden Widerstände im wesentlichen gleichartig sind.

Die Kontaktierung eines Wicklungssdrahtes mit einem Kollektor erfolgt üblicherweise durch Preßschweißen, wozu ein hakenförmiger Anschluß der Lamelle um das Drahtende gebogen und verschweißt wird. Dabei ist die Kontaktierung mehr oder weniger gleichmäßig, wobei durch die Schweißung ein Übergangswiderstand $R_{Ui}$ zwischen Wicklungswiderstand $R_{Wi}$ und Lamelle $L_i$ verbleibt, der normalerweise im Mikroohmbereich liegt. Im Rahmen der Motorenfertigung müssen die Übergangswiderstände $R_{Ui}$ bei Prüfung der Läufer einzeln gemessen werden.

In FIG 3 ist ein Teilbereich aus FIG 2 dargestellt, wobei im wesentlichen nur drei Leiterzweige betrachtet zu werden brauchen. Der Übergangswiderstand $R_X$ im mittleren Leiterzweig soll gemessen werden. Dafür ist dem Netzwerk im ersten Zweig eine Stromquelle 50 zugeordnet, welche einen Strom $I_I$ liefert. Dem mittleren Zweig ist eine zweite Stromquelle 60 zugeordent, welche einen zu $I_I$ entgegengesetzten Strom $I_2$ einstellbarer Größe liefert. Die zugehörige Spannung $U_X$ ist über ein Meßgerät 85 meßbar. Außerdem ist im dritten Leiterzweig ein Shuntwiderstand 70 eingeschaltet, bei dem die über den vorgegebenen Widerstand abfallende Spannung in einem Meßgerät 75 gemessen wird.

Zur Messung werden folgende Einzelschritte durchgeführt:

Ia) Drei parallele Lamellen 32 bis 34 des Kollektors 3 mit Lamellen 3I bis 42 werden kontaktiert.

Ib) Die Stromquelle $I_I$ wird so eingestellt, daß der maximal zulässige Strom, den der Wicklungsdraht führen kann, fließt. Von diesem Strom, der direkt proportional der Spannung am Meßgerät 75 ist, fließt etwa ein Drittel über den Shuntwiderstand 70 ab. Insbesondere ist die Spannung am Verknüpfungspunkt A dann Null, wenn der Strom durch den Shuntwiderstand 70 gleich Null ist. Die Genauigkeit des Stromes $I_I$ des Shuntwiderstandes 70, dessen Widerstandswert im Ohmbereich liegt, und dessen Kontaktierung gehen in die Meßgenauigkeit nicht ein.

Ic) Anschließend wird die Stromquelle $I_2$ so hochgeregelt, bis der durch den Widerstand 70 fließende Strom Null wird. Damit ist aber auch die Spannung am Meßgerät 75 gleich Null.

Id) Die Spannung $U_X$ am Meßgerät 85 und der mittels Stromquelle 60 vorgegebene Strom $I_2$ werden präzise gemessem, wobie hier wiederum die Kontaktierungswiderstände nicht eingehen.

Ie) Aus den vorhanden Meßwerten ist der Widerstand $R_X = U_X/I_2$ ermittelbar.

Da der gesuchte Widerstand im Mikroohm-Bereich liegt, muß die Spannungsmessung möglichst genau erfolgen, was beispielsweise mit Digitalvoltmetern mit 0,I Mikrovolt Auflösung möglich ist. Der Strom $I_2$ läßt sich dagegen vergleichsweise einfach bestimmen, wofür der Stromquelle 60 ein Meßgerät 65 vorgeschaltet sein kann.

Bei der beschriebenen Methode wird ein Analog-Meßverfahren angewendet. Es können so die Übergangswiderstände an den Wicklungsanschlüssen eines Kommutators nacheinander durchgemessen werden.

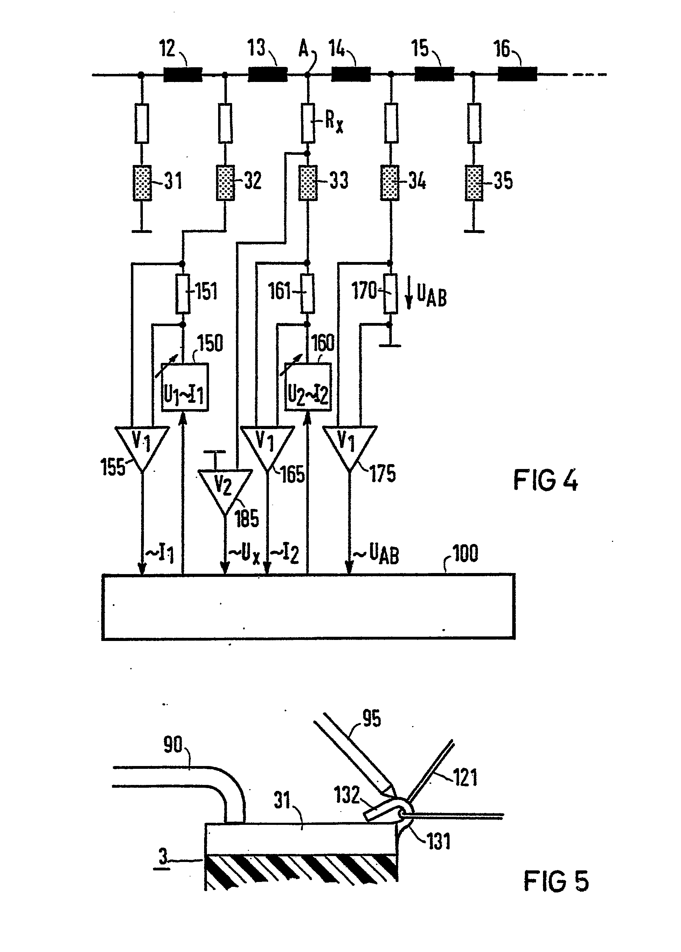

In FIG 4 bedeutet I00 ein Mikroprozessorsystem, z.B. das System SMP, mit Ein- und Ausgabeeinheiten, welche gleichermaßen die notwendigen Mittel zur Analog/Digital- bzw. Digital/Analog-Wandlung beinhalten. Dem oben be schriebenen Netzwerk aus drei parallel geschalteten Leitern mit jeweils einem Lamellenwiderstand, einem Wikklungswiderstand und zugehörigem Übergangswiderstand sind im wesentlichen der FIG 3 entsprechende Spannungsquellen bzw. Meßeinrichtungen zugeordnet, welche jetzt aber digital arbeiten. Im einzelnen bedeuten I50 und I60 zwei Spannungsquellen zur Lieferung der Spannungen $U_I$ und $U_2$, wobei $U_I$ auf den ersten Leiterzweig und $U_2$ auf den mittleren Leiterzweig, d.h. den Meßzweig, einwirken, Da statt der Stromquellen nunmehr Spannungsquellen verwendet werden, sind den Spannungsquellen I50 und I60 jeweils Meßwiderstände I5I und I6I vorgeschaltet, bei denen die über die vorgegebenen Widerstände abfallenden Spannungen über Verstärker I55 und I65 als Spannungsmesser gemessen werden. Weiterhin sind im dritten Leiterzweig entsprechend FIG 3 ein Shuntwiderstand I70 mit zugehörigem Verstärker I75 als Spannungsmesser, sowie im Meßzweig ein Verstärker I85 zur Bestimmung der am Übergangswiderstand $R_X$ abfallenden Spannung $U_X$ bei potentialfreiem Knotenpunkt A des Netzwerkes vorhanden. Die Verstärker 155, 165 und 175 sind einstufig mit Verstärkung $V_1$, der Verstärker 185 zweistufig mit Verstärkung $V_2$ aufgebaut. Die entsprechend verstärkten Signale gelangen über Eingangsleitungen in das Mikroprozessorsystem 100 zur digitalen Meßwertverarbeitung zwecks Ausgabe von Steuersignalen für die Spannungsquellen 150 und 160.

Die Messung des gesuchten Übergangswiderstandes $R_x$ erfolgt nun weitgehend programmiert unter Mikroprozessorkontrolle. Dabei wird folgender Programmablauf vorgenommen:

IIa) Die Lamellen werden entsprechend Pkt. Ia kontaktiert.

IIb) Es erfolgt ein automatischer Offset-Abgleich aller Verstärker der Spannungsmesser 155, 165, 175 und 185. Damit werden gleichzeitig alle Thermospannungen, die in der Größenordnung des Nutzsignales liegen können, eliminiert. Es ist somit die Auflösung im Mikroohmbereich realisierbar.

IIc) Die Spannungsquelle 150 mit Spannung $U_1$ wird soweit hochgefahren, bis der maximal zulässige Strom durch den Draht fließt. Dabei wird zunächst die Streckenverstärkung gemessen und anschließend der Sollwert aufgeschaltet. Es ist ein schnelles digitales Einregeln im Bereich von Millisekunden erreichbar.

IId) Die Spannungsquelle 160 mit der Spannung $U_2$, die zu $U_1$ entgegengesetzter Polarität hat, wird so eingeregelt, daß die über den Meßwiderstand 170 abfallende Spannung $U_{AB}$ gleich Null wird. Dabei wird wiederum zunächst die Streckenverstärkung gemessen und anschließend der Sollwert aufgeschaltet. Durch mehrmaliges Nachstellen ist es möglich, den exakten Nullwert zu erreichen, wobei wiederum ein schnelles digitales Einregeln erfolgen kann.

IIe) Die über den Meßwiderstand 161 abfallende Spannung $U_2$ wird über den Verstärker 165 gemessen, woraus der zugehörige Strom $I_2$ ermittelbar ist. Weiterhin wird $U_x$ über den Verstärker 185 gemessen, so daß sich wie bei der Schaltung nach FIG 3 der schweißwiderstand $R_x = U_x/I_2$ ermitteln läßt.

Insbesondere durch den gleichzeitigen Offset-Abgleich der einzelnen Verstärker 155, 165, 175 und 185 sowie durch bekannte Zeit-Integration, beispielsweise über 20 ms bei 50 Hz Netzfrequenz, lassen sich Störungen bzw. Fremdsignale weitgehend unterdrücken, so daß der interessierende Hakenwiderstand in Mikroohmbereich erfaßbar ist.

In FIG 5 ist eine einzelne Kollektor-Lamelle 31 des Kommutators 3 gezeigt, welche am vorderen Ende mit einem Haken 131 zur Aufnahme des Wicklungsdrahtendes 121 ausgebildet ist. Eine Stromzuführung ist mit 90 und eine Meßsonde für Spannungen mit 95 bezeichnet. Zur Kontaktierung wird üblicherweise das Wicklungsdrahtende 121 in den Haken 131 eingelegt und der Haken 131 zusammengepreßt und verschweißt.

Es hat sich gezeigt, daß es vorteilhaft ist, die Meßsonde 95 jeweils am stromlosen Teil 132 des Hakens 131 aufzusetzen. Es kann damit die Auflösung des Meßverfahrens weiter gesteigert werden, so daß eine höchstgenaue Meßwerterfassung im Mikroohmbereich gewährleistet ist.

## Patentansprüche

1. Verfahren zum Messen des Übergangswiderstandes von Leitungsanschlüssen in einem Netzwerk elektrisch parallel geschalteter Leiter, die im wesentlichen gleichartig sind, insbesondere der Schweißwiderstände zwischen Wicklungen und Kollektor-Lamellen bei elektrischen Motoren, **dadurch gekennzeichnet**, daß jeweils im Netzwerk mit drei Zweigen gemessen wird, von denen der im mittleren Zweig befindliche Übergangswiderstand bestimmt werden soll, wozu

a) in einem ersten Verfahrensschritt über den ersten Zweig dem Netzwerk ein definierter Strom ($I_1$) bzw. eine definierte Spannung ($U_1$) eingeprägt wird und

b) in einem zweiten Verfahrensschritt im mittleren Meßzweig ein dem in diesem Meßzweig fließendem Strom gleichgroßer Gegenstrom ($I_i$) bzw. Gegenspannung ($U_2$) eingeprägt wird, so daß der Verknüpfungspunkt (A) der Leiter auf Nullpotential liegt, und

c) die dafür notwendige Spannung ($U_x$) gemessen wird, woraus der Übergangswiderstand ($R_x$) im mittleren Zweig ohne den Leiterwiderstand ermittelbar ist.

2. Verfahren nach Anspruch 1, **dadurch gekennzeichnet**, daß der in das Netzwerk eingeprägte Strom ($I_i$) bzw. die dazu notwendige Spannung ($U_x$) derart bemessen wird, daß der für die Leiter maximal zulässige Strom fließt.

3. Verfahren nach Anspruch 1, **dadurch gekennzeichnet**, daß bei Verfahrensschritt b) die Nullkompensation den Spannung am Verknüpfungspunkt (A) der Leiter durch Messung des Stromes über einen dem dritten Leiter vorgeschalteten Hilfswiderstand (70) erfaßt wird.

4. Verfahren nach Anspruch 1, **dadurch gekennzeichnet**, daß zur Einstellung des Stromes digital steuerbare Spannungsquellen (150, 160) verwendet werden.

5. Verfahren nach Anspruch 1, **dadurch gekennzeichnet**, daß die Messignale von Strom oder Spannung digitalisiert und digital ausgewertet und als Steuersignale für die Spannungsquellen verarbeitet werden.

6. Meßanordnung zur Durchführung des Verfahrens nach Anspruch 1 oder einem der Ansprüche 2 bis 5 mit Strom- bzw. Spannungsquellen, einer Meßsonde für Spannungen sowie zugehörigen Spannungsmeßeinrichtungen, **dadurch gekennzeichnet**, daß im Netzwerk dem ersten und zweiten Leiter jeweils eine Strom- bzw. Spannungsquelle (50, 60; 150, 160) mit entgegengesetzter Polarität zugeordnet sind und daß die Strom- und Spannungsquellen (50, 60; 150, 160) auf diskrete Werte einstellbar und im Meßbetrieb vom eingestellten Stromwert ($I_1$, $I_2$) auf die bei diesem Konstantstrom notwendige Spannung ($U_1$, $U_2$) umschaltbar sind.

7. Meßanordnung nach Anspruch 6, **dadurch gekennzeichnet**, daß im dritten Leiterzweig ein Meßwiderstand (70, l70) mit parallelgeschaltetem Spannungsmesser (75, l75) angeordnet ist.

8. Meßanordnung nach Anspruch 6, **dadurch gekennzeichnet**, daß die Strom- bzw. Spannungsquellen (l50, l60) programmierbar sind.

9. Meßanordnung nach Anspruch 8, **dadurch gekennzeichnet**, daß zur Auswertung der Meßsignale und zur Steuerung der Strom bzw. Spannungsquelle (l50, l60) in Abhängigkeit von den Meßwerten ein Mikroprozessorsystem (l00) vorhanden ist.

l0. Meßanordnung nach Anspruch 6, zur Messung des Schweißwiderstandes zwischen dem Drahtende einer Wicklung und einer Kollektor-Lamelle, welche endseitig einen Haken zum Anschweißen des Wicklungsdrahtes bildet, dadurch gekennzeichnet, daß die Meßsonde (95) für Spannungen am nicht stromführenden Teil des Lamellen-Hakens (l3l) aufgesetzt ist.

## Claims

1. Method of measuring the contact resistance of conductor terminals in a network of electrically parallel-connected conductors which are substantially similar, particularly the resistances of welds between windings and collector segments in electric motors, characterised in that measurement are carried out in each case in the network with three branches of which the contact resistance located in the central branch is to be determined, for which purpose.
   a) a defined current ($I_1$) or a defined voltage ($U_1$) is introduced into the network via the first branch in a first step of the method and
   b) in a second step of the method a reverse current ($I_2$) of equal magnitude to the current flowing in the central measurement branch or a reverse voltage ($U_2$) is introduced into the central measurement branch so that the connection point (A) of the conductors lies at zero potential, and
   c) the voltage ($U_x$) necessary therefor is measured, and from it the contact resistance ($R_x$) in the central branch without the conductor resistance can be determined.

2. Method according to claim 1, characterised in that the current ($I_1$) or the voltage ($U_x$) necessary therefor which is introduced into the network is measured in such a way that the maximum current permissible for the conductor flows.

3. Method according to claim 1, characterised in that in step b) of the method the zero compensation of the voltage at the connection point (A) of the conductors is determined by measuring the current through an auxiliary resistance 70 connected before the third conductor.

4. Method according to claim 1, characterised in that digitally controllable voltage sources (150, 160) are used for setting the current.

5. Method according to claim 1, characterised in that the measurement signals of the current or voltage are digitalised and digitally analysed and processed as control signals for the voltage sources.

6. Measuring arrangement for carrying out the method according to claim 1 or one of claims 2 to 5 with current or voltage sources, a measuring probe for voltages as well as appertaining voltage measuring arrangements, characterised in that in the network a current or voltage source (50, 60; 150, 160) with opposite polarity is associated in each case with the first and second conductor, and the current and voltage sources (50, 60; 150, 160) can be set to discrete values and during the measuring operation can be switched from the set current value ($I_1$, $I_2$) to the voltage ($U_1$, $U_2$) necessary for this constant current.

7. Measuring arrangement according to claim 6, characterised in that a measurement resistance (70, 170) with a parallel-connected voltmeter (75, 175) is arranged in the third conductor branch.

8. Measuring arrangement according to claim 6, characterised in that the current or voltage sources (150, 160) are programmable.

9. Measuring arrangement according to claim 8, characterised in that a microprocessor system (100) is provided for analysis of the measurement signals and for control of the current or voltage sources (150, 160) in dependence upon the measurement values.

10. Measuring arrangement according to claim 6, for measuring the weld resistance between the wire end of a winding and a collector segment which forms a hook at the end for the winding wire to be welded on, characterised in that the measuring probe (95) for voltages is placed on the part of the segment hook (131) which does not conduct current.

## Revendications

1. Procédé pour mesurer la résistance de contact de connexions conducteurs dans un réseau de conducteurs électriques branchés en parallèle, qui sont sensiblement d'un même type, notamment des résistances de soudage entre des enroulements et des lamelles de collecteurs dans des moteurs électriques, caractérisé par le fait qu'on réalise les mesures dans le réseau respectif avec trois branches parmi lesquelles on doit mesurer la résistance de contact présente dans la branche centrale, ce pourquoi
   a) lors d'une première étape opératoire, on applique un courant défini ($I_1$) ou une tension définie ($U_1$) au réseau par l'intermédiaire de la première branche, et
   b) lors d'une seconde étape opératoire, on applique, dans la branche médiane de mesure, un courant opposé ($I_2$) possédant la même intensité que le courant circulant dans cette branche de mesure, ou une tension opposée ($U_2$), en sorte que le point de jonction (A) des conducteurs est placé à un potentiel nul, et
   c) on mesure la tension ($U_x$) nécessaire à cet effet, à partir de laquelle on peut déterminer la résistance de contact ($R_x$) dans la branche médiane, sans la résistance des conducteurs.

2. Procédé suivant la revendication 1, caractérisé par le fait qu'on donne au courant ($I_1$) injecté

dans le réseau ou à la tension ($U_x$) nécessaire à cet effet de manière à faire circuler le courant maximal admissible pour les conducteurs.

3. Procédé suivant la revendication 1, caractérisé par le fait que, lors de l'étape opératoire b), on détecte la compensation du zéro de la tension au niveau du point de jonction (A) du conducteur par la mesure du courant dans une résistance auxiliaire (70) branchée en aval du troisième conducteur.

4. Procédé suivant la revendication 1, caractérisé par le fait que pour régler le courant, on utilise des sources de tension (150, 160), pouvant être commandées numériquement.

5. Procédé suivant la revendication 1, caractérisé par le fait qu'on numérise et on évalue numériquement les signaux de mesure du courant ou de la tension et qu'on les traite en tant que signaux de commande pour les sources de tension.

6. Dispositif de mesure pour la mise en œuvre du procédé suivant la revendication 1 ou l'une des revendications 2 à 5, comportant des sources de tension, une sonde de mesure pour de tension, ainsi que des dispositifs de mesure de tension associés, caractérisé par le fait que, dans le réseau, aux premier et second conducteurs sont associées des sources respectives de courant ou de tension (50, 60; 150, 160) possédant une polarité opposée, et qu'on peut régler les souces de courant et de tension (50, 60; 150, 160) sur des valeurs discrètes et les commuter, pendant l'opération de mesure, d'une valeur de courant réglée ($I_1$, $I_2$) sur la tension ($U_1$, $U_2$) nécessaire pour ce courant constant.

7. Dispositif de mesure suivant la revendication 6, caractérisé par le fait qu'une résistance de mesure (70, 170), en parallèle avec laquelle est branché un voltmètre (75, 175), est montée dans la troisième branche de mesure.

8. Dispositif de mesure suivant la revendication 6, caractérisé par le fait que les sources de courant ou de tension (150, 160) sont porgrammables.

9. Dispositif de mesure suivant la revendication 8, caractérisé par le fait qu'il est prévu un système à microprocesseur (100) pour évaluer les signaux de mesure et pour commander les sources de courant ou de tension (150, 160) en fonction des valeurs de mesure.

10. Dispositif de mesure suivant la revendication 6, pour la mesure de la résistance de soudage entre l'extrémité du fil d'un enroulement et une lamelle de collecteur, qui forme, sur son extrémité, un crochet permettant de souder le fil de l'enroulement, caractérisé par le fait que la sonde (95) de mesure de tension est appliquée sur la partie, non placée sous tension, du crochet (131) de la lamelle.

FIG 1

FIG 2

FIG 3

FIG 4

FIG 5